Europäisches Patentamt

European Patent Office

Office européen des brevets

(11) Publication number: **0 272 418 B1**

# EUROPEAN PATENT SPECIFICATION

(45) Date of publication of patent specification: **16.09.92**

(21) Application number: **87116337.4**

(22) Date of filing: **05.11.87**

(51) Int. Cl.5: **C23C 16/26**, C23C 16/50, C30B 25/02, C30B 29/04, C30B 25/10

(54) **Apparatus and process to condensate diamond.**

(30) Priority: **22.12.86 US 944729**

(43) Date of publication of application:
**29.06.88 Bulletin 88/26**

(45) Publication of the grant of the patent:
**16.09.92 Bulletin 92/38**

(84) Designated Contracting States:
**AT BE CH DE FR GB IT LI SE**

(56) References cited:
**EP-A- 0 161 829**
**EP-A- 0 230 927**

**CHEMICAL ABSTRACTS, vol. 103, no. 22, December 1985, page 123, no. 180319n, Columbus, Ohio, US; & JP-A-60 118 694 (MITSUBISHI METAL CORP.) 26-06-1985**

**PATENT ABSTRACTS OF JAPAN, vol. 7, no. 277 (C-199)[1422], 9th December 1983; & JP-A-58 156 594 (SUMITOMO DENKI KOGYO K.K.) 17-09-1983**

**PATENT ABSTRACTS OF JAPAN, vol. 12, no.**

**373 (C-534)[3220], 6th October 1988; & JP-A-63 123 896 (TORAY IND. INC.) 27-05-1988**

(73) Proprietor: **GENERAL ELECTRIC COMPANY**
**1 River Road**
**Schenectady New York 12305(US)**

(72) Inventor: **Anthony, Thomas Richard**
**2142 Lynwood Drive**
**Schenectady New York 12309(US)**
Inventor: **DeVries, Robert Charles**
**17 Van Vorst Drive**
**Burnt Hills New York 12027(US)**

(74) Representative: **Catherine, Alain et al**
**General Electric France Service de Propriété Industrielle 18 Rue Horace Vernet**
**F-92136 Issy-Les-Moulineaux Cedex(FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

This invention relates to condensate diamond, and more particularly to process and apparatus for use in the production of diamond crystals as condensate, from a hydrogen-hydrocarbon gas mixture, on a substrate.

Diamond is a mineral usually consisting of nearly pure carbon in crystal form. It is the hardest natural substance known and finds wide application not only as a precious stone for jewelry applications, but also industrially, as a metal cutting tool or tool insert, and in small particle form, as a metal grinding or abrading material.

It is known in the prior art that, under conditions of very high pressures and temperatures, graphite in the presence of certain catalyst metals, can be converted or caused to undergo a transition from the graphite or non-diamond carbonaceous material form to the diamond form of carbon (U.S- A -2,947,610 - Hall et al).

It is also known in the prior art that diamond form of carbon will condense from a high carbon content gas plasma on a substrate (U.S - A -4,434,188 - Kamo). This latter method is usually referred to as a chemical vapor deposition method (CVD). While the CVD process has a number of salient advantages for diamond production, its diamond production in terms of mass is quite low, and this feature limits its present use as a commercial diamond production tool.

Chemical Abstracts, vol. 103, n° 22, december 1985, page 123, abstract n° 180319n and JP-A-60118694 disclose a process for the synthesis of diamonds which comprises introducing a gas mixture of hydrocarbon and $H_2$ into a furnace and depositing diamond by activating the gas mixture with a hot filament and at the same time creating a plasma by using a frequency of 13.56 MHz.

Patent Abstracts of Japan, vol. 7, n° 277 (C-199) [1422], 9th December 1983 and JP-A-58/156594 disclose a process for applying a hard diamond film on a substrate by introducing a gaseous mixture of hydrocarbons and hydrogen into a closed metal containing a heated substrate and heating the gas with red-hot metal wire and at the same time generating a plasma in the gas. The plasma is reacted through the use of a RF coil.

Accordingly, it is an object of this invention to provide an improved diamond production apparatus and an improved high yield, CVD process therefor.

It is another object of this invention to provide improved control of a diamond product in a CVD process.

These and other objects, features and advantages of this invention will be better understood when taken in connection with the following detailed description when read in conjunction with the accompanying drawings.

FIG. 1 is a side elevational and sectional view of an apparatus useful for the practice of this invention.

FIG. 2 is a top and sectional view of the apparatus of FIG. 1 and its associated components useful for the practice of this invention.

FIG. 3 is an enlarged side elevational view of a modification of the apparatus of FIG. 1 wherein an additional electrical resistance heater coil is included as well as a different arrangement for gas delivery.

FIG. 4 is a flow diagram of the gas flow components which deliver gases into the reaction chamber of FIGS. 1 and 3.

FIG. 5 is a curve illustrating diamond growth with respect to time in the practice of this invention.

In accordance with the present invention, a gas mixture of hydrogen and a hydrocarbon gas is passed over a heated metal filament adjacent a substrate. The gas mixture in the vicinity of the substrate is continuously exposed to electromagnetic microwave energy to become a luminescent gas plasma from which diamond is deposited on the substrate. The metal filament and the substrate are also continuously exposed to electromagnetic microwave energy. In one practice of this invention, a mixture of hydrogen gas and a hydrocarbon gas, methane, is introduced into a reaction chamber where the mixture is passed over an electrical resistance metal heater filament and concurrently subjected to microwave energy to form a luminescent gas plasma adjacent a substrate. The luminescent gas plasma contains a significant amount of atomic hydrogen and is caused to come into contact with the substrate to deposit an increased yield of diamonds, from the gas plasma, on the substrate.

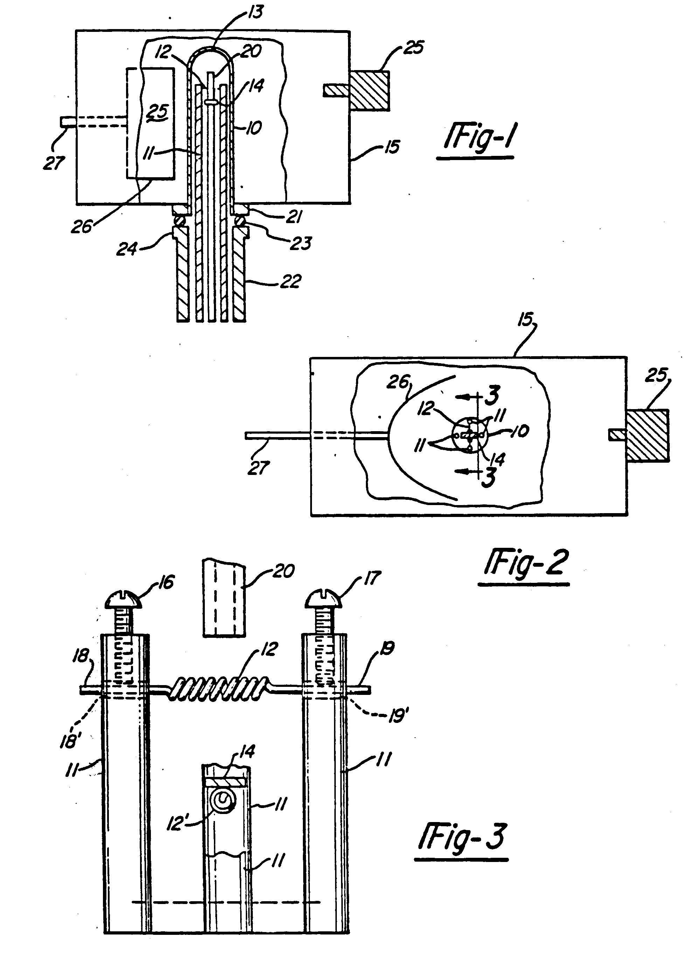

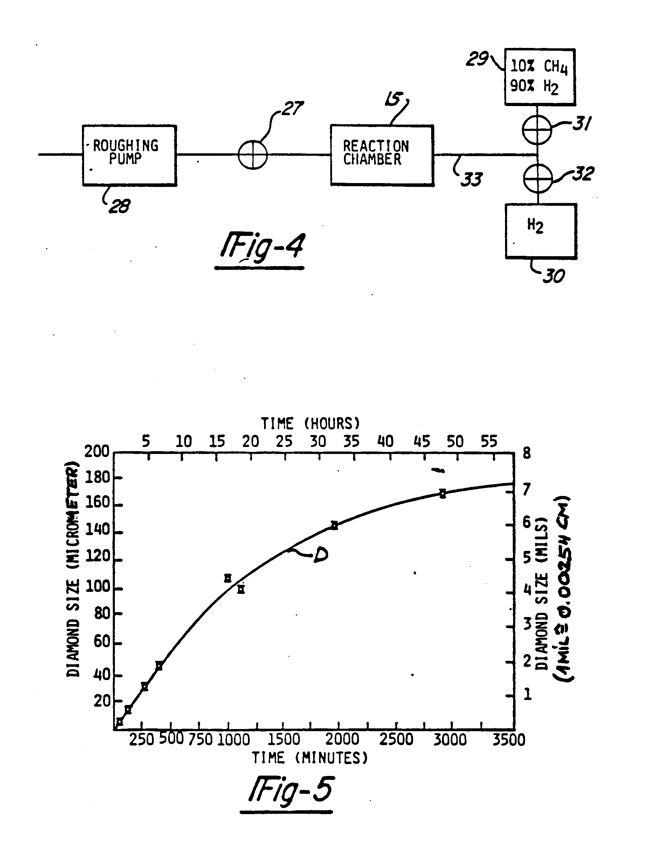

Referring now to FIG. 1, there is illustrated one apparatus and its components which are useful in the practice of this invention. The apparatus of FIG. 1 includes a reaction chamber which, in one example, is a quartz tube 10, a material so chosen because of its high temperature resistance, its low reactance with respect to the gases employed in this invention, and its transparency with respect to microwave radiation. Within tube 10 there are four small diameter, parallel, refractory metal rods 11 (2 not shown) which are spaced from each other in tube 10 in a square configuration, as illustrated in FIG. 2. In one practice of this

EP 0 272 418 B1

invention, rods 11 are molybdenum metal rods of 6.35mm (1/4 inch) diameter.

An electrical resistance heater coil or filament 12 is supported within tube 10 near the closed end 13 thereof by a pair of diagonally opposite rods 11 while a substrate 14 is supported within tube 10 by the other pair of diagonally opposite rods 11. A top view of the rods 11, heater coil 12, substrate 14 and their arrangement is shown in FIG. 2. Referring to FIG. 2, quartz tube 10 contains the four parallel molybdenum rods 11 in a square configuration where an opposite two rods support the transverse heater coil 12 while the other opposite two rods support substrate 14.

In FIGS. 1 and 2, a large microwave cavity member 15 encloses tube 10 with the molybdenum rods 11, heater coil 12 and substrate 14 therein. A more functional illustration of heater coil 12 and substrate 14 is shown in FIG. 3.

Referring to FIG. 3, which is a view of FIG. 2 taken along the line 3-3 thereof, one pair of opposite molybdenum rods 11 support heater coil 12 there between. The other pair of rods 11 support an additional heater coil 12' there between for the purpose of heating substrate 14. The closest or forefront rod is not shown for the purpose of clarity. Electrical contact means, particularly for coil 12 (and similarly for coil 12') include screws 16 and 17 which are threaded into the ends of molybdenum rods 11 to engage the leads 18 and 19, respectively, of heater coil 12 in apertures 18' and 19' in molybdenum rods 11. Molybdenum rods 11 are connected to a source of electrical power (not shown) so that electrical current flows from one rod 11 through coil 12 or 12' to an opposite rod 11. By this means, electrical resistance heater coils-12 and 12' may be heated to temperatures in excess of 2000°C.

A quartz gas inlet tube 20 is connected to a source of hydrogen and a hydrocarbon gas and terminates adjacent the heater coil 12 as shown in FIG. 3, or, may be centrally and vertically disposed in tube 10 to terminate with its open end adjacent the closed end 13 of tube 10 as illustrated in FIG. 1. In FIG. 1, quartz tube 10 is concentrically sealed to a sealing ring 21 in gas-tight relationship. Sealing ring 21, in turn, is sealed to cavity member 15 in gas-tight relationship. An exhaust conduit 22 is sealed to ring 21 in gas-tight relationship by means of a ring gasket 23 interposed between ring 21 and flange 24 of conduit 22. Conduit 22 serves as a gas exhausting conduit to exhaust the gas being introduced into tube 10 adjacent closed end 13 by means of inlet tube 20.

In one practice of this invention a gas mixture of hydrogen and a hydrocarbon gas is introduced into tube 10 by means of gas inlet tube 20. The gas mixture passes over heater coil 12, which has been heated by the passage of electrical current there through, to above 2000°C, and impinges substrate 14 on which diamond form of carbon is deposited from the gas. It has been discovered that the use of microwave energy concurrently with the use of a high temperature coil 12 provides a marked increase in growth rate in mass yield of diamond crystals as well as an increase in crystal size. For example, microwave energy alone will produce a diamond growth of less than one half micrometer per hour. The use of a high temperature coil alone will provide a diamond growth rate of one micrometer per hour. However, when used together, microwave energy together with a heated coil will synergistically provide diamond growth rates of ten to twenty micrometers per hour.

Microwave energy is conveniently supplied by an electromagnetic microwave generator 25 as illustrated in FIGS. 1 and 2.

Referring again to FIG. 1, electromagnetic microwave generator 25 may take the form of a well known device commonly referred to as a magnetron. Electromagnetic microwave generator 25 is shown attached to one side of cavity 15 which is referred to as a microwave cavity, being constructed of materials which reflect and do not dissipate microwave energy. Cavity 15 encloses the structure of FIG. 1, principally tube 10 and its contents. In order to focus the microwave energy in cavity 15, a microwave reflector 26 is employed. Reflector 26 is a parabolic aluminum reflector having an adjusting rod 27 attached thereto and extending out of cavity 15. During the practice of this invention, heater coil 12 is energized so that the gas mixture passes over the hot surface of heater coil 12. Thereafter microwave generator 25 is energized to introduce microwave energy into cavity 15. Reflector 26 is adjusted so that microwave energy is focused inside tube 10 in the general region (FIG. 3) of the end of gas inlet tube 20, coil 12 and substrate 14. The gas is caused to become a plasma with a high degree of luminescence adjacent substrate 14. A significant amount of atomic hydrogen is formed in the gas flow and it is estimated that about 50% of the gas adjacent the high temperature coil is atomic hydrogen. Diamonds may be produced in accordance with the practice of this invention utilizing the heater coil alone or the electromagnetic wave generator alone for production of diamond. However, in the practice of this invention a greatly increased production yield and crystal size are obtained where there is concurrent use of tungsten heater coil 12 and electromagnetic wave generator 25 as energy sources for a combined beneficial effect on the gas mixture. For example, the heater coil provides a very hot surface in immediate contact with the gas mixture to favor those reactions in the gas mixture which tend to increase the concentration of the condensate which is deposited on the substrate.

The microwave energy generates a plasma in the gas containing a significant quantity of atomic hydrogen and stimulates the condensate to a highly active state just prior to deposition of diamond from the gas phase. The combined stimulation of the gas by a hot surface and by microwave energy, directly adjacent the substrate, as well as the direct stimulation of the substrate and hot surface by impinging microwave radiation, leads to favorable diamond deposition from the gas phase. The condition described results in the maximum use of each stimulation, in combination, and without significant dissipation or decay, immediately preceding diamond deposition.

Since the coil 12 and microwave generator 25 are concurrently energized, the gas mixture which comes into contact with coil 12 is simultaneously subjected to microwave stimulation and heat energy stimulation. Crystal size per diamond crystal formed with only a filament heater such as heater coil 12, or only a microwave generator such as 25 are about 10 micrometers or less in the largest dimension, whereas with combined microwave energy and heat energy from coil 12, crystal sizes of more than 100 micrometers have been achieved.. Under prolonged conditions of combined microwave and heat energy, diamond crystals of 180 micrometers in their longer dimensions have been formed.

Diamond growth rates also show a large increase with the combined use of coil 12 and microwave generator 25. With the coil 12 or microwave generator alone, diamond grow rates are of the order of 1 micrometer per hour or less. When coil 12 and microwave generator 25 are used in combination, diamond growth rates as high as 20 micrometers per hour are achieved.

Best results were obtained in the practice of this invention when the gas utilized was a mixture of hydrogen and a hydrocarbon gas.

Hydrogen gas was 99.9% pure in order to exclude those impurities which might enter into and affect the reaction taking place, or impurities which might enter into the diamond crystal being deposited on the substrate. Methane gas was selected as the hydrocarbon gas because it is readily available, economical and has a high carbon content. However, other high carbon content gases may also be employed in the practice of this invention, acetylene gas being one example. Also certain gases may be utilized, which, during exposure to the hot surface of coil 12 as well as to microwave energy may form a high carbon content gas or provide a rich source of hydrogen.

In the gas mixture as described, it is preferred that hydrogen comprise at least about 95% by volume of the mixture and the hydrocarbon gas less than 5% of the mixture. A preferred mixture is about 98% hydrogen and about 2% hydrocarbon gas such as methane.

Heater coil 12 is an important feature of this invention. Coil 12 is a filamentary electrical resistance heater capable of maintaining a temperature of above about 2000°C without undue deterioration over the time of the process cycle. Ordinarily, a tungsten metal coil adequately serves these purposes. However, a tungsten coil whose temperature is about 2000°C reacts with the hydrocarbon gas to form tungsten carbide. The volume of tungsten carbide is greater than that of metallic tungsten and causes expansion cracking and mechanical failure of the filament. In order to overcome this problem and to provide for the use of tungsten as a favorable material for coil 12, a conditioning procedure was utilized. In this procedure a tungsten coil 12 is heated relatively slowly to a temperature of about 2000°C in the presence of a hydrocarbon gas followed by constant temperature of about 2000°C for about 30 minutes. Slow heating and a constant elevated temperature leads to the formation of a coating or layer of tungsten carbide on coil 12. The coating or layer protects the remainder of the coil from undergoing defect generating carbide formation.

In the practice of this invention heater coil 12 was a helically wound coil formed from tungsten wire commercially referred to as 218 tungsten. A characteristic of 218 tungsten wire is that the crystal or grain structure is columnar, extending longitudinally in the wire. Accordingly, the formation of tungsten carbide along the grain structure is less likely to cause breakage of the wire as would the formation of tungsten carbide along a lateral grain structure. Wire diameter was 0.508mm (0.02 inch). Axial length of coil 12 was 38.1mm (1.5 inches), including leads 18 and 19. The helix portion of coil 12 was 19.5mm (0.75 inch) length with 18 coils or turns. Coil diameter (1D.) was 3.175mm (0.125 inch).

While the particular size of the coil 12 does not appear to be critical, it has been found that much larger sizes of wire diameter as well as helix diameter seems to result in an increased deposition of non-diamond carbon on the substrate 14 which may be caused by having too high of gas temperature.

Substrate 14 is an important component of this invention. Substrate 14 is being impinged by the hot gas in tube 10 and microwave radiation and is selected to be of a material resistant to high temperatures and the gases utilized. Furthermore, carbon is being continually diffused into the substrate 14 during the practice of this invention, a diffusion which has not been found conducive to diamond deposition. Accordingly, a material is preferred which is resistant to the high temperatures and less reactive to the hot gas environment. One preferred material is a refractory metal such as molybdenum, as compared to ferrous metals. Under the conditions of the process of this invention a refractory metal such as molybdenum will react with the hot gas to form a protective carbide layer thereon which is highly resistant to carbon diffusion.

Consistently good results are obtained when substrate 14 comprises a section of molybdenum foil. Molybdenum appears to be conducive to diamond deposition in this invention. Substrate 14 was spaced about 8.128mm (0.32 inch) below the filament heater coil 12.

In the practice of this invention it was found that a negative temperature gradient in the gas between the coil 12 and substrate 14 was desirable. With a substrate temperature somewhat less than the temperature of coil 12 and less than the adjacent gas temperature, diamond deposition appeared to be more favorable. Diamond deposition is favored when the gas flowing between gas inlet 20 and substrate 14 flows down a negative temperature gradient so as to cool the gas and cause supersaturation of a condensate species in the gas that generates diamond deposition and growth.

This invention provides increased control over important parameters as gas mixture, coil 12 temperature, and substrate 14 materials and temperatures, and control over these parameters may provide deposited diamonds with predetermined characteristics. For example, when small amounts of an additional gas such as diborane and phosphine are introduced into tube 10 boron and phosphorous atoms are incorporated into the diamond crystal which then become electrically semiconductive. The CVD process as practiced in this invention facilitates the addition of atoms of various materials into the diamond crystal structure.

It is important in the commercial production of diamond not only to have an increased mass yield, but also to have improved recovery of the diamond crystals. In this invention as described, diamond crystals are easily removed from molybdenum foil by light scraping and flexing. It was discovered that diamond crystals are deposited preferentially on a molybdenum foil on graphite markings on the foil.

A graphite substrate is surprisingly conducive to diamond deposition and growth. Also, boron, boron compounds and alloys containing dissolved boron caused preferential deposition and growth of diamond crystals relative to all other substrate materials. A substrate from which diamonds are easily removed is a carbon filament substrate. In one embodiment of this invention the substrate 14 comprises a loosely wound carbon filament mass. This mass provided a significant exposed area for diamond deposition, and because of its flexible nature diamond crystals were easily removed therefrom. Accordingly, an improved substrate may comprise a loose wool-like mass of non-woven carbon filaments. Other substrate materials may also affect the kind of diamond crystal deposited thereon. Table I gives the relative rates of diamond nucleation and growth on various substrate materials. Boron and boron-containing compounds and materials give the highest growth rates. Graphite and metals give intermediate growth and nucleation rates while oxides give the lowest diamond nucleation and growth rates.

Table I

| Relative Diamond Growth Rates on Various Substrate Materials | |
| --- | --- |
| Material | Relative Growth Rate mass/unit time |
| B | 5220 |
| BN | 3760 |
| Pt | 548 |
| Graphite | 400 |
| An | 400 |
| Mo | 400 |
| Cu | 400 |
| ALN | 95 |
| Ag | 86 |
| Fe | 69 |
| Ni | 57 |
| Si | 48 |
| $Al_2O_3$ | 55 |
| $SiO_2$ | 1 |

For example, a smooth boron nitride surface is conducive to diamond crystal deposition and provides a smooth layer or coating of diamond crystals on its exposed surface.

A laminate diamond structure may also be produced by this invention. For example, it has been discovered that a diamond crystal is a substrate which is conducive to diamond crystal deposition in this invention. A larger diamond crystal with a smooth planar surface may be used as a substrate. The practice of this invention provides an extremely smooth film of epitaxial single-crystal deposited diamond on the diamond substrate. When this diamond substrate is used in a further practice of this invention with the deposited film layer exposed as a substrate surface, a further extremely smooth epitaxial single-crystal diamond film layer is superimposed on the first layer and coextensively tightly bounded thereto. A repetition of this process provides a laminate diamond comprising a sandwich structure of individual diamond laminae superimposed on each other and tightly bonded to each other. Furthermore, each layer may have different characteristics. For example, during the process of depositing the layers, each layer may be doped with a material such as boron or antimony so that each layer may have different electrical semiconductive characteristics.

Composite substrates such as, for example, molybdenum or platinum on silica, have been used for low pressure synthesis of diamond. The desirable properties such as growth rate promotion and heat conduction of substrate materials can be combined. Composite substrates can be designed to provide high growth rate at low cost. Additionally, composite substrates can be used with direct substrate heating with appropriate currents and voltages. Composite substrates also facilitate harvesting of diamond.

Diamond grain produced by the process of this invention has been used to form cemented diamond compacts by passing an activated hydrogen-hydrocarbon gas over a layer of diamond powder. Diffusion into the powder layer and deposition of diamond cements the mass together. Densification was found to continue until interstices between powder particles were blocked.

A diamond layer on substrates other than diamond is a polycrystalline diamond film or coating on a substrate. There appears to be two stages in the diamond deposition process. In the first stage there is profuse nucleation of discrete diamond crystals on the substrate. In the second stage the discrete diamond crystals grow, collide and merge with adjacent crystals to form the layer or film. When a diamond laminate is formed, a clear and distinct interface is not apparent between layers. Each layer seems to coalesce with adjacent layers and is coextensively tightly bonded thereto. A diamond layer may be an extremely advantageous wear resistant surface in many applications such as bearing and journal surfaces. A diamond layer may also be conveniently applied to metal cutting tool inserts.

In the practice of this invention it was found that a refractory metal substrate such as molybdenum forms a molybdenum carbide coating thereon by reason of its exposure to high temperature and a hydrocarbon gas. Diamond is then expeditiously deposited on the carbide coating. Low pressure deposition of diamond on tungsten carbide substrate has been achieved using the methods disclosed herein. Hard metal carbides are employed as metal cutting tools or tool inserts. Accordingly, a diamond film or layer may be deposited on predetermined areas or surfaces of these hard carbide or nitride tools or inserts which are surfaces conducive to diamond deposition by the practices of this invention. The diamond layer of this invention is usually a hard optically black film and accordingly may be deposited on an article which is to be incorporated into an optical device.

Carbon fibers having a diameter of 1 to 2 micrometers have been used as a growth substrate for diamond produced by low pressure synthesis at temperatures of 1030° to 1080°C in the apparatus of this invention.

Other substrate materials upon which diamond has been deposited include silicon carbide, pyrolytic graphite, boron nitride, boron doped silicon, and aluminum nitride .

Best results are obtained in the practice of this invention to produce films when the substrate temperature is about 600°C or below. Films have been obtained with substrate temperatures as low as 400°C. Higher temperatures and longer time cycles favor larger discrete crystal growth.

This invention provides an improved measure of control of a CVD process of producing diamond and the process disclosed and described is amenable to changes in its operating parameters.

A gas delivery process and an apparatus utilized therefor in one practice of this invention are described with respect to FIG. 4.

Referring now to FIG. 4, a pair of gas storage tanks 29 and 30 are interconnected by means of gas flow control valves 31 and 32 to a common conduit 33 which is connected to inlet tube 20 of reaction chamber tube 10 of FIG. 1. Storage tank 29 is filled with a mixture of 90% by volume of hydrogen $H_2$ and 10% by volume of methane $CH_4$ gases. Storage tank 30 is filled with hydrogen alone. By utilizing a mixture of gases in one tank 29 and a single gas in the other tank 30, flow valves 31 and 32 can be easily maintained to provide smaller and more precise changes in the gas mixture flowing through conduit 33 to the reaction chamber tube 10 of FIG. 1 which is within cavity 15.

Diamond crystals have also been grown on a liquid metal substrate by direct vapor-to-solid growth.

6

These crystals were found to be cubic and octahedral. Deposition on metals and metal alloys having melting points below the deposition temperature provides for continuous harvesting from the liquid surface by mechanical means.

The deposition of diamond crystals on high strength wire such as piano wire has been shown to be a convenient method for making diamond cutting wire by a process in which the diamond growth is stopped and the wire substrate is completely covered by the growing diamond. Then a metal such as copper is plated onto the partially diamond-covered wire to a depth slightly less than the height of the diamond crystals to hold them firmly in place.

The low pressure synthesis of diamond according to this invention can be used to form wire drawing dies by forming a relatively thick layer of diamond on a metal wire having a diameter equal to the desired internal diameter of the die. The coated wire with its hard shell of diamond can then be mounted in brazing alloy or steel mounting which is formed so that the periphery of the outer case is concentric with the wire. The wire can then be removed, e.g., by dissolving or etching in an acid bath to form this completed die.

The diamond produced on a substrate according to the process of this invention can be described as half diamonds corresponding to cleaved cubic or octahedral crystals. Once on the substrate, the diamond grows on surfaces exposed to the gas phase. The use of a supportive gas phase to levitate a growing crystal provides means for growing uniform crystals. In such a process, an updraft in a reactor tube is created sufficient to levitate diamonds of different sizes along the length of the tube, which is of narrower diameter at the bottom. The wider top operates to reduce the updraft to a degree which will not lift small diamond nuclei upward. The reactive gas in the tube is activated by microwave radiation with the use of a hot central filament so that diamond growth takes place throughout the tube.

The following example is indicative of a preferred practice of this invention which is favorable to certain changes in, for example, temperature, gas mixture and time cycle, to obtain changes in the characteristics of the resultant condensate diamond.

EXAMPLE I

Utilizing the apparatus of FIG. 1, a mixture of 1.7% methane and 98.3% hydrogen, by volume, was continuously passed through the reaction chamber at a flow rate of 44 cm$^3$/min. The gas pressure in the reaction chamber was constant at about 119.7 Pa (9.0 Torr). A constant current of about 24 amps was applied to a tungsten coil electrical resistance heater resistor 12 resulting in a coil temperature of about 2100°C. The microwave generator device 25 was operated at 500 watts from an electrical power source of 110-120 volts, 60 Hz, to emit microwave radiation with a frequency of 2450 MHz and a wavelength of 12.14 cm. During the practice of this invention as described, use of the combination of thermal heating from coil 12 and microwave energy from microwave device 25 to form a gas plasma, results in a substrate 14 temperature of about 750°C. Under these conditions there is a negative temperature gradient between heater coil 12 and substrate 14 and between the temperature of the gas plasma and the temperature of substrate 14. The microwave device 25 is continuously energized for the duration of a timed process so that it operates concurrently with heating of coil 12 and continuously throughout a process cycle. The microwave reflector was then adjusted so that peak luminescence appeared in the plasma flow adjacent substrate 14.

The above example was repeated for duration times of from 30 minutes to 48 hours resulting in the deposition of a great number of diamond crystals on the substrate. When the process conditions are quickly established and discontinued after about 30 minutes, rapid nucleation of profuse, very small diamond crystals occurs. With longer periods of time the discrete, small crystals grow to a significant size.

Some results of the practice of this invention as exemplified by Example I are shown in FIG. 5.

Referring now to FIG. 5, Curve D represents diamond crystal growth with respect to time. It is to be noted that process times of about 30 minutes yield diamond crystals of about 10$\mu$m in their longer dimension. When the combination of electrical resistance coil heating and microwave energy insertion is continued for about 48 hours, diamond crystals are obtained which approach 180$\mu$m in their larger dimension. This is a most significant increase in size as compared to the practice of the process of this invention without concurrent microwave energy, as described, where crystal size is noted to be no more than about 10$\mu$m in the longer dimension after a period of many hours (ten hours).

Deposits obtained by the practice of this invention were submitted to X-ray and electron diffraction tests as well as to optical microscopic examination at 1000X and Raman spectroscopy. These tests reveal that the deposits of condensate diamond contain the cubic crystal structure associated with a diamond carbon crystal.

In the practice of this invention it was discovered that diamond growth is significantly increased as a function of the temperature of the substrate.

If the substrate temperature reaches the temperature where graphitization of diamond crystal occurs, it would be expected that only the non-diamond form of carbon would be deposited, and, if diamond were to be deposited under these conditions, a strong tendency towards graphitization of the diamond crystal would be expected. Substrate heating is expeditiously carried out by electrical resistance heating. For example, as illustrated in FIG. 3, a pair of opposite molybdenum rod electrodes 11 supply electrical power to resistance heater tungsten coil 12 for purposes as described. An opposite two molybdenum rod electrodes provide electrical power to an additional electrical resistance heater coil 30.48cm (12') on which substrate 13 rests and is heated thereby.

One example of the practice of this invention at higher temperatures is as follows wherein a 3/4 inch diameter molybdenum disc 6.35mm (1/4 inch) thick was employed as the substrate 14.

EXAMPLE II

(A) A mixture of 1% methane and 99% hydrogen was introduced through tube 20 of FIG. 1 into tube 10. Flow rate was 38 $cm^3$/min.

(B) Heater coil 12 was energized with a current flow there through of 27.3 amperes which raised the temperature of the coil 12 to above 2100°C.

(C) The microwave generator 24 was energized at 500 watts and reflector 25 adjusted to focus microwave energy into gas tube 10 to generate a plasma therein adjacent the substrate 14.

(D) Gas pressure in tube 10 was maintained constant at 4056.5 Pa (30.5 Torr).

(E) Coil 12' was energized to cause the substrate 14 temperature to increase to about 1100°C. as measured with an optical pyrometer.

The above conditions were maintained for a total of 6.0 hours. At the expiration of this time period the above temperatures were reduced by deenergizing the heater coil 12 and microwave generator, and closing off the flow of gas into tube 10. Substrate 14 was then removed from tube 10 and was found to be covered with black diamond crystals. Cavity 15 is fitted with a transparent panel so that diamond growth on the substrate could be observed during the six hour period. The growth rate of the diamond crystals was in the range of 6 to 10.0 micrometers per hour. Substrate temperatures of above 1000°C serve to increase both crystal size and mass yield of diamond as compared to a substrate temperature of about 750°C. Lower substrate temperatures, for example, below about 750°C tend to provide a layer or film of discrete diamond crystals on a substrate.

In the practice of this invention a hydrogen-hydrocarbon gas mixture is conditioned through simultaneous stimulation of (a) subjection to contact with a heater surface at elevated temperature and (b) exposure to microwave energy insertion. The conditioned gas is then caused to decompose on a substrate and deposit diamond form of carbon thereon.

By the practice of this invention which combines microwave and heat energy in a CVD diamond process, marked increase in mass yield of diamond is obtained. Also various diamond modifications are obtained such as electrical semiconductive diamonds and diamonds with atoms of various materials incorporated in their crystal structure. Layered or laminate diamonds are also available as are diamond layers on various functional articles.

In addition to the use of bottled gas as the source of reactive gases, unused gas, principally hydrogen, can be passed over hot graphite, e.g., rods or a fluidized bed, to form mere methane which is then recycled to the reaction chamber.

**Claims**

1. An apparatus for the production of diamond by the CVD method comprising in combination:
    (a) a reaction chamber,
    (b) gas inlet means in said reaction chamber to introduce a gas mixture of hydrogen and hydrocarbon gases therein to flow into said chamber,
    (c) exit means connected to said reaction chamber to evacuate gas therefrom and to establish flow of gas through said reaction chamber,
    (d) a metallic electrical resistance heater member in said reaction chamber adjacent said gas inlet means and positioned so that the flow of gas from said gas inlet means flows over said heater member,
    (e) a substrate mounted in said reaction chamber adjacent said heater member to be impinged by the gas flow over said electrical resistance heater in said reaction chamber,
    (f) electrical connection means associated with said heater member to connect said heater member to a source of electrical power to raise the temperature of said heater member to above 2000°C to provide a reaction surface for the gas flow in said reaction chamber,

(g) an electromagnetic microwave energy generator associated with said reaction chamber and adapted to inject microwave energy into the gas flowing in said reaction chamber and against said heater member and said substrate to generate a gas plasma with atomic hydrogen therein adjacent said substrate so that the gas plasma is coursed to condense on said substrate and deposit diamond form of carbon thereon as condensate from said plasma.

2. An apparatus as recited in Claim 1 wherein said resistor heater member is a tungsten, molybdenum, rhenium, or alloys thereof, metal wire coil.

3. An apparatus as recited in Claim 2 wherein said substrate is a non-metal.

4. An apparatus as recited in anyone of claims 1 to 3 wherein said substrate comprises carbon filaments.

5. An apparatus as recited in Claim 3 wherein said non-metal is boron or a boron-containing compound.

6. An apparatus as recited in Claim 3 wherein said non-metal is graphite.

7. An apparatus as recited in anyone of claims 1 to 6 wherein an additional electrical resistance heater coil is associated with said substrate to raise the temperature thereof.

8. An apparatus as recited in anyone of claims 1, 2 or 7 wherein said substrate comprises a liquid metal or alloy.

9. An apparatus as recited in anyone of claims 1, 2 or 7 wherein said substrate metal is molybdenum.

10. A CVD process for producing the diamond form of carbon from the condensation of a carbonaceous gas onto a substrate characterized in that it comprises:

passing a mixture of hydrogen and hydrocarbon gases across a refractory metal surface heated to above 2000°C and concurrently subjecting said mixture of gases to microwave energy to generate a gas plasma with atomic hydrogen therein, thereby depositing the diamond form of carbon on said substrate and removing the diamond form of carbon from said substrate.

11. The CVD process of claim 10 characterized in that the concurrent action of the refractory metal surface and the microwave energy takes place in a region adjacent the substrate.

12. The CVD process of claims 10 or 11 characterized in that the substrate is heated.

13. The CVD process of claim 12 characterized in that said substrate is heated at a temperature in the range of 1000°C to 2500°C.

14. The CVD process of claim 12 characterized in that said substrate is heated at a temperature in the range of 400°C to 750°C.

15. The CVD process according to anyone of the preceding claims wherein said substrate is a refractory metal.

16. The CVD process according to claim 15 wherein said substrate is molybdenum metal foil.

17. The CVD process according to anyone of claims 10 to 14 wherein said substrate is a non-metal.

18. The CVD process of claim 17 wherein said substrate comprises loose carbon filaments.

19. The process according to anyone of the preceding claims wherein said refractory metal surface is tungsten.

20. The process according to anyone of the preceding claims wherein the gases further include diborane or phosphine.

21. The process according to anyone of the preceding claims wherein there is a negative temperature gradient between the heated refractory metal surface and the substrate.

**Patentansprüche**

1. Einrichtung zur Diamantherstellung durch das chemische Dampfabscheidungs(CVD)-Verfahren, enthaltend in Kombination:

    (a) eine Reaktionskammer

    (b) eine Gaseinlaßeinrichtung in der Reaktionskammer zum Einführen einer Gasmischung von Wasserstoff- und Kohlenwasserstoffgasen, um in die Kammer zu strömen,

    (c) eine Ausgangseinrichtung, die mit der Reaktionskammer verbunden ist, um Gas zu evakuieren und eine Gasströmung durch die Reaktionskammer hindurch auszubilden,

    (d) ein metallisches elektrisches Widerstands-Heizteil in der Reaktionskammer, das neben der Gaseinlaßeinrichtung und so angeordnet ist, daß die Gasströmung von der Gaseinlaßeinrichtung über das Heizteil strömt,

    (e) ein Substrat, das in der Reaktionskammer neben dem Heizteil angebracht ist, damit die Gasströmung über das elektrische Widerstands-Heizteil in der Reaktionskammer darauf aufprallt,

    (f) dem Heizteil zugeordnete elektrische Verbindungsmittel zum Verbinden des Heizteils mit einer Quelle elektrischer Energie, um die Temperatur des Heizteils auf mehr als 2000°C anzuheben, um eine Reaktionsfläche für die Gasströmung in der Reaktionskammer auszubilden,

    (g) einen Generator für elektromagnetische Mikrowellenenergie, der der Reaktionskammer zugeordnet und in der Lage ist, Mikrowellenenergie in das in der Reaktionskammer strömende Gas und gegen das Heizteil und das Substrat einzuführen, um ein Gasplasma mit atomarem Wasserstoff darin neben dem Substrat zu erzeugen, damit das Gasplasma auf dem Substrat kondensiert und eine Diamantform von Kohlenstoff darauf als Kondensat aus dem Plasma abscheidet.

2. Einrichtung nach Anspruch 1, wobei das Widerstands-Heizteil eine Metalldrahtspule aus Wolfram, Molybdän, Rhenium oder Legierungen davon ist.

3. Einrichtung nach Anspruch 2, wobei das Substrat ein Nichtmetall ist.

4. Einrichtung nach einem der Ansprüche 1 bis 3, wobei das Substrat Kohlefasern aufweist.

5. Einrichtung nach Anspruch 3, wobei das Nichtmetall Bor oder eine borhaltige Verbindung ist.

6. Einrichtung nach Anspruch 3, wobei das Nichtmetall Graphit ist.

7. Einrichtung nach einem der Ansprüche 1 bis 6, wobei eine zusätzliche elektrische Widerstands-Heizspule dem Substrat zugeordnet ist, um dessen Temperatur zu erhöhen.

8. Einrichtung nach einem der Ansprüche 1, 2, oder 7, wobei das Substrat ein flüssiges Metall oder Legierung aufweist.

9. Einrichtung nach einem der Ansprüche 1, 2 oder 7, wobei das Substratmetall Molybdän ist.

10. Chemisches Dampfabscheidungs(CVD)-Verfahren zur Erzeugung der Diamantform von Kohlenstoff aus der Kondensation eines kohlenstoffhaltigen Gases auf einem Substrat, gekennzeichnet durch:

    Leiten einer Mischung von Wasserstoff- und Kohlenwasserstoffgasen über eine Oberfläche aus hochwarmfesten Metall, die auf mehr als 2000°C erhitzt ist, und gleichzeitiges Aussetzen der Gasmischung gegenüber Mikrowellenenergie, um ein Gasplasma mit atomarem Wasserstoff darin zu erzeugen, wobei die Diamantform von Kohlenstoff auf dem Substrat abgeschieden wird, und Entfernen der Diamantform von Kohlenstoff von dem Substrat.

11. CVD-Verfahren nach Anspruch 10, dadurch gekennzeichnet, daß die gleichzeitige Aktion der Oberfläche von hochwarmfesten Metall und der Mikrowellenenergie in einem Bereiche neben dem Substrat erfolgt.

**12.** CVD-Verfahren nach Anspruch 10 oder 11, dadurch gekennzeichnet, daß das Substrat erhitzt wird.

**13.** CVD-Verfahren nach Anspruch 12, dadurch gekennzeichnet, daß das Substrat auf eine Temperatur in dem Bereich von 1000 bis 2500°C erhitzt wird.

**14.** CVD-Verfahren nach Anspruch 12, dadurch gekennzeichnet, daß das Substrat auf eine Temperatur in dem Bereich von 400 bis 750°C erhitzt wird.

**15.** CVD-Verfahren nach einem der vorstehenden Ansprüche, wobei das Substrat ein hochwarmfestes Metall ist.

**16.** CVD-Verfahren nach Anspruch 15, wobei das Substrat eine Molybdänmetallfolie ist.

**17.** CVD-Verfahren nach einem der Ansprüche 10 bis 14, wobei das Substrat ein Nichtmetall ist.

**18.** CVD-Verfahren nach Anspruch 17, wobei das Substrat lose Kohlefasern aufweist.

**19.** Verfahren nach einem der vorstehenden Ansprüche, wobei die Oberfläche aus hochwarmfesten Metall Wolfram ist.

**20.** Verfahren nach einem der vorstehenden Ansprüche, wobei die Gase ferner Diboran oder Phosphin enthalten.

**21.** Verfahren nach einem der vorstehenden Ansprüche, wobei ein negativer Temperaturgradient zwischen der erhitzten Oberfläche aus hochwarmfesten Metall und dem Substrat besteht.

## Revendications

**1.** Appareil pour la production de diamant par le procédé CVD (dépôt chimique à partir d'une phase gazeuse) comprenant en combinaison :
(a) une chambre de réaction,
(b) un moyen d'admission de gaz dans ladite chambre de réaction pour introduire dans cette dernière un mélange gazeux d'hydrogène et d'hydrocarbures, de telle manière qu'il s'écoule dans ladite chambre,
(c) un moyen d'échappement raccordé à la chambre de réaction pour en évacuer le gaz et pour établir un écoulement de gaz à travers ladite chambre de réaction,
(d) un élément de chauffage à résistance électrique métallique dans ladite chambre de réaction à proximité du moyen d'admission de gaz et disposé de manière telle que le gaz en provenance du moyen d'admission de gaz s'écoule sur ledit élément de chauffage,
(e) un substrat monté dans la chambre de réaction à proximité de l'élément de chauffage, de manière à être heurté par le gaz s'écoulant sur l'élément de chauffage à résistance électrique dans la chambre de réaction,
(f) un moyen de connexion électrique associé à l'élément de chauffage pour connecter l'élément de chauffage à une source de courant électrique afin d'élever la température de l'élément de chauffage au-dessus de 2000°C de manière que soit formée une surface de réaction pour l'écoulement du gaz dans ladite chambre de réaction,
(g) un générateur électromagnétique d'énergie micro-onde associé à la chambre de réaction et adapté pour injecter une énergie micro-onde dans le gaz s'écoulant dans la chambre de réaction et contre l'élément de chauffage et le substrat de manière à engendrer un plasma avec l'hydrogène atomique présent dans cette chambre à proximité du substrat, de telle sorte que le plasma soit amené à se condenser sur le substrat et à déposer sur ce dernier du carbone sous forme de diamant en tant que condensat dudit plasma.

**2.** Appareil selon la revendication 1, dans lequel l'élément de chauffage à résistance est un enroulement de fil en tungstène, en molybdène, en rhénium, ou en des alliages de ces métaux.

**3.** Appareil selon la revendication 2, dans lequel le substrat est en un matériau non métallique.

**4.** Appareil selon l'une quelconque des revendications 1 à 3, dans lequel le substrat comprend des filaments de carbone.

**5.** Appareil selon la revendication 3, dans lequel le matériau non métallique est du bore ou un composé contenant du bore.

**6.** Appareil selon la revendication 3, dans lequel le matériau non métallique est du graphite.

**7.** Appareil selon l'une quelconque des revendications 1 à 6, dans lequel un enroulement supplémentaire d'élément de chauffage à résistance électrique est associé au substrat pour élever la température de ce dernier.

**8.** Appareil selon l'une quelconque des revendications 1, 2 ou 7, dans lequel le substrat comprend un métal ou alliage liquide.

**9.** Appareil selon l'une quelconque des revendications 1, 2 ou 7, dans lequel le métal du substrat est du molybdène.

**10.** Procédé CVD (dépôt chimique à partir d'une phase gazeuse) pour produire du carbone sous forme de diamant à partir de la condensation d'un gaz carboné sur un substrat, caractérisé en ce qu'il comprend les étapes consistant :

à faire passer un mélange d'hydrogène et d'hydrocarbures sur une surface métallique réfractaire chauffée jusqu'à une température supérieure à 2000°C et à soumettre en même temps le mélange des gaz à une énergie micro-onde pour engendrer un plasma avec l'hydrogène atomique qui s'y trouve de manière à déposer ainsi sous forme de diamant le carbone sur ledit substrat et à enlever de ce substrat le carbone sous forme de diamant.

**11.** Procédé CVD selon la revendication 10, caractérisé en ce que l'action conjointe de la surface métallique réfractaire et de l'énergie micro-onde a lieu dans une région adjacente au substrat.

**12.** Procédé CVD selon les revendications 10 ou 11, caractérisé en ce que le substrat est chauffé.

**13.** Procédé CVD selon la revendication 12, caractérisé en ce que le substrat est chauffé à une température comprise entre 1000°C et 2500°C.

**14.** Procédé CVD selon la revendication 12, caractérisé en ce que le substrat est chauffé à une température comprise entre 400°C et 750°C.

**15.** Procédé CVD selon l'une quelconque des revendications précédentes, dans lequel le substrat est un métal réfractaire.

**16.** Procédé CVD selon la revendication 15, dans lequel le substrat est une mince feuille de molybdène.

**17.** Procédé CVD selon l'une quelconque des revendications 10 à 14, dans lequel le substrat est un matériau non métallique.

**18.** Procédé CVD selon la revendication 17, dans lequel le substrat comprend des filaments de carbone dans une disposition non serrée.

**19.** Procédé selon l'une quelconque des revendications précédentes, dans lequel la surface métallique réfractaire est du tungstène.

**20.** Procédé selon l'une quelconque des revendications précédentes, dans lequel les gaz comprennent, en outre, du diborane ou de la phosphine.

**21.** Procédé selon l'une quelconque des revendications précédentes, dans lequel il existe un gradient de température négatif entre la surface métallique réfractaire chauffée et le substrat.

12

_Fig-1_

_Fig-2_

_Fig-3_

*IFig-4*

*IFig-5*